# EUROPÄISCHE PATENTSCHRIFT

(11) **EP 1 522 606 B1**
(45) Veröffentlichungstag und Bekanntmachung des Hinweises auf die Patenterteilung: **09.12.2009**
(21) Anmeldenummer: 03022987.6
(22) Anmeldetag: 10.10.2003
(51) Int. Cl.: C23C 14/00, C23C 14/08, C23C 14/56

(54) **Verfahren zur Beschichtung von bandförmigem Material mit schwarzem Aluminiumoxid**
Method for coating strip-shaped material with black aluminium oxide
Procédé pour revêter d'un materiau en forme de bande avec oxyde noir d'aluminium

(43) Veröffentlichungstag der Anmeldung: 13.04.2005
(73) Patentinhaber: Fraunhofer-Gesellschaft zur Förderung der angewandten Forschung e.V., 80686 München (DE)
(72) Erfinder: Schiller, Nicolas, Dr., 01833 Stolpen OT Helmsdorf (DE); Straach, Steffen, 01187 Dresden (DE); Rank, Rolf, Dr., 01127 Dresden (DE); Zeissig, Gerhard, 01259 Dresden (DE); Günther, Steffen, 01309 Dresden (DE)

(56) Entgegenhaltungen:
- DE-C- 19 845 268
- US-A- 5 766 827
- US-B1- 6 296 895

## Beschreibung

Die Erfindung betrifft ein Verfahren zur Vakuumbeschichtung von Kunststofffolien in Vakuum-Bandbedampfungsanlagen mit einer nahezu schwarzen Schicht aus Aluminiumoxid gemäß Anspruch 1.

Derartige beschichtete Kunststofffolien können als laserbeschreibbare Folien eingesetzt werden. Außerdem lassen sich derartige Folien zu anderen Zwecken, beispielsweise für dekorative Anwendungen, einsetzen.

Es ist bekannt, dass in Vakuum-Bandbedampfungsanlagen vorzugsweise Kunststofffolien, aber auch Papiere, Textilmaterialien und andere bandförmige Substrate mit verschiedenen Funktionsschichten beschichtet werden, um ihre physikalischen Eigenschaften zu verändern. Eine beispielhafte Anwendung dieses Verfahrens ist die Beschichtung von Kunststofffolien oder Papier mit Aluminium für Kondensatoren oder Verpackungsfolie. Derartige Bedampfungsverfahren zeichnen sich insbesondere durch eine hohe Produktivität aus.

Es sind verschiedene Verfahren zu Herstellung laserbeschreibbarer Folien bekannt (EP 0 688 678 A1, EP 0 645 747 A2, WO 98/16397, US 5,766,827). Kern dieser Verfahren ist, dass eine Folie hergestellt wird, die aus einer mittels eines Lasers optisch veränderbaren Schicht und einem Trägermaterial besteht. Die Produkte unterscheiden sich vor allem im Aufbau der laserbeschreibbaren Schicht und im Aufbau der gesamten ggf. laminierten Folie.

Es ist bekannt, als laserbeschreibbare Schicht eine aufgedampfte Aluminiumschicht zu nutzen (WO 98/16397). Diese wird beim Beschreiben durch den Laserstrahl weitgehend vom Substrat entfernt. Eine vorteilhafte Ausführungsform besteht darin, dem Trägermaterial eine Kontrastfarbe beizufügen. Durch gezielte Abtragung der laserbeschreibbaren Schicht in der Spur des Lasers ergibt sich damit eine gute und kontrastreiche Bildwirkung bzw. gute Lesbarkeit. Häufig kommen opake Substrate zum Einsatz. Dadurch lassen sich laserbeschreibbare Folien auf verschiedenen Untergründen mit weitgehend gleichem visuellen Eindruck verwenden.
Nachteilig ist, dass eine Aluminiumschicht einen großen Teil der Energie des Lasers reflektiert. Um eine weitgehend vollständige Entfernung der Aluminiumschicht beim Beschreiben zu erreichen, muss deshalb mit hohen Energiedichten operiert werden, was mit der Gefahr einer Schädigung des Substrates verbunden ist.

Als Verdampfungsverfahren für die Beschichtung mit Aluminium in Bandbedampfungsanlagen kommen beispielsweise das Elektronenstrahlverdampfen und das thermische Verdampfen aus keramischen Schiffchenverdampfern zum Einsatz. Diese Verfahren gestatten es, bandförmige Substrate mit hoher Produktivität zu beschichten. Bei der Herstellung von beschichteten Produkten, deren visueller Eindruck von Bedeutung ist, macht sich häufig eine Regelung der Aluminiumschichtdicke erforderlich. Zur Regelung der Aluminium-Schichtdicke existieren verschiedene Verfahren, bei denen unmittelbar nach der Beschichtung noch in der Beschichtungsanlage (in-line-Verfahren) der elektrische Widerstand der Aluminiumschicht oder durch eine Transmissionsmessung die optische Dichte des beschichteten Substrates gemessen werden und die Aluminium-Verdampfungsrate oder die Bandgeschwindigkeit entsprechend angepasst werden. Welches der beiden Messverfahren eingesetzt wird, hängt in der Regel vom Schichtdickenbereich und von der Substratart ab. So kann z. B. bei opaken Substraten die optische Dichte des beschichteten Substrates nicht ohne erheblichen Aufwand für eine Charakterisierung der Beschichtung herangezogen werden.

Es ist weiterhin bekannt, mit schwarzem Aluminiumoxid beschichtete Folien für die Herstellung von laserbeschreibbaren Folien einzusetzen.
Aus US 5,766,827 ist eine laserbeschreibbare Schicht aus schwarzem, unterstöchiometrischem Aluminiumoxid mit einem Sauerstoffgehalt von mindestens 19 bis weniger als 58 Atomprozent und einer optischen Dichte von mindestens 0,3 bekannt. Diese Aluminiumoxidschicht kann durch Verdampfen von Aluminium in einer sauerstoffhaltigen Umgebung aufgebracht werden. Dieses Verfahren führt zu einer Verbesserung der Absorption der Energie des Lasers. Allerdings hinterlassen derartige Beschichtungen häufig den Eindruck sichtbar ungleichmäßiger Schichtzusammensetzungen.

Es ist aus zahlreichen Anwendungen bekannt, Bandmaterial mit stöchiometrischem oder unterstöchiometrischem Aluminiumoxid zu beschichten. Mit transparenten nahezu stöchiometrischen Aluminiumoxidschichten beschichtete Folien werden z. B. als Verpackungsfolie in der Lebensmittelindustrie eingesetzt. Die Aluminiumoxidschicht erfüllt den Zweck einer Barriereschicht gegen die Permeation von Sauerstoff und Wasserdampf. Zur Beschichtung von Kunststofffolien mit Aluminiumoxid haben sich zwei Möglichkeiten etabliert:
- die Verdampfung von Aluminium aus Schiffchenverdampfern und Zugabe von Sauerstoff in den Verdampfungsraum, die sogenannte reaktive Verdampfung, und
- die Verdampfung von Aluminiumoxid, vorzugsweise durch Elektronenstrahlverdampfung. Dissoziationsprozesse und unterschiedlich schnelles Abpumpen der Dissoziationsprodukte erfordern auch bei diesem Verfahren eine Zugabe von Sauerstoff, um Aluminiumoxid abzuscheiden.

Typischerweise unterliegt in Bandbedampfungsanlagen hoher Produktivität die Aluminium-Verdampfungsrate oder die räumliche Verteilung von Sauerstoff oder Metalldampf Schwankungen, die zu Schwankungen der Schichtdicke und der Verteilung von Sauerstoff und Aluminium in der Aluminiumoxidschicht führen. All das führt zu einer unterschiedlichen lokalen Zusammensetzung der aufgedampften Aluminiumoxidschicht, was sich in deutlich sichtbaren Schwankungen der Transmission bzw. des Farbeindruckes der Schicht äußert. Wie bei der Aluminiumverdampfung wird also häufig von der Notwendigkeit ausgegangen, die Al-Verdampfungsrate zu regeln. Hinzu kommt bei der Beschichtung mit Aluminiumoxid oft die Notwendigkeit, die Stöchiometrie zu regeln. Unter Stöchiometrie wird dabei die tatsächliche Zusammensetzung der Schicht aus Aluminium und Sauerstoff verstanden, deren Anteile in Aufdampfschichten deutlich von den aus der chemischen Formulierung resultierenden abweichen können.
Insbesondere bei Anwendungen, die auf einen visuellen Eindruck abzielen, kommt einer genauen Einhaltung von Schichtdicke und Stöchiometrie eine große Bedeutung zu, da schon geringe Schwankungen zu deutlich wahrnehmbaren Änderungen des visuellen Eindrucks bezüglich der optischen Dichte und der Farbe führen. Das trifft in besonderem Maße auf Anwendungen in laserbeschreibbaren Produkten zu.

GB 2 246 794 A beschreibt ein Verfahren zur Herstellung von Metalloxidschichten durch Verdampfen des Metalls in Vakuum unter sauerstoffhaltiger Atmosphäre, ohne Hinweise zur Einstellung der gewünschten Schichteigenschaften (z. B. Schichtdicke, optische Transparenz) anzugeben.

DE 44 27 581 A1 offenbart ein Verfahren zur Herstellung optisch transparenter Metalloxidschichten. Gemäß diesem Verfahren wird eine schwach unterstöchiometrische und damit schwach absorbierende Metalloxidschicht auf eine Kunststofffolie abgeschieden. Die schwache Absorption wird genutzt, um über optische Sensoren die optische Transparenz und daraus die Schichtdicke zu bestimmen und die Aufdampfrate zu steuern. Weiterhin wird nach Ermittlung der optischen Transparenz eine Nachoxidation der Schicht vorgenommen. Dadurch können ursprünglich sichtbare Schwankungen der Transparenz deutlich reduziert werden. Dieses Verfahren ist nur für die Herstellung nahezu transparenter Schichten, nicht aber zur Herstellung schwarzer Aluminiumoxidschichten geeignet. Gerade diese sind aber für laserbeschreibbare Materialien von Interesse. Hinzu kommt, dass die gewonnenen Messwerte oft nicht eindeutig einer zu regelnden Größe zugeordnet werden können, da die gemessene optische Transparenz sowohl von der Schichtdicke als auch von der Stöchiometrie der Metalloxidschicht abhängt.

DE 198 45 268 C1 beschreibt ein Verfahren zur Abscheidung von im Wesentlichen transparenten Aluminiumoxidschichten hoher Barrierewirkung. Gemäß diesem Verfahren wird gezielt in Bandlaufrichtung ein Gradient des Sauerstoffpartialdruckes erzeugt und damit auch ein Gradient des Oxidationsgrades über der Schichtdicke. Dieser Gradient wird so optimiert, dass bei gleicher optischer Transmission der Gesamtschicht die Wasserdampfpermeation ein Minimum erreicht. Dieses Verfahren ist für die Herstellung schwarzer Aluminiumoxidschichten nicht geeignet, da die Sichtbarkeit von Stöchiometrieschwankungen durch die extrem geringe Dicke des absorbierenden Schichtbereichs reduziert wird. Damit verbunden ist eine insgesamt geringe Absorption.

Es ist weiterhin bekannt, bandförmige Substrate mit unterstöchiometrischem, schwarzem Aluminiumoxid oder Aluminium/Aluminiumoxid-Wechselschichten oder Gradientenschichten zu beschichten. Das Patent US 4,430,366 beschreibt ein Verfahren zur Herstellung einer Beschichtung bestehend aus mindestens zwei Komponenten aus Metall und Metalloxiden, u.a. auch Aluminium und Aluminiumoxid. Diese Beschichtung wird durch Metallverdampfung und kontrollierter Zufuhr von Sauerstoff oder Wasserdampf in zwei verschiedene Bereiche des Metalldampfes erzeugt, während das bandförmige Substrat durch diese Metalldampfbereiche bewegt wird. Nachteil dieses Verfahrens ist, dass es keine Vorschriften zur gezielten Einstellung einer Schichtfärbung enthält. Angaben zur Schwarzfärbung beziehen sich auf die Angabe einer optischen Dichte, die jedoch bei opaken Substraten nicht messbar ist. Selbst bei transparenten Substraten kann man durch Bestimmung der optischen Dichte nicht zwischen einer metallischen Aluminiumschicht und einer unterstöchiometrischen, stark absorbierenden nahezu schwarzen Aluminiumoxidschicht unterscheiden.

Die Verwendung von schwarzen Aluminiumoxidschichten zur Herstellung laserbeschreibbarer Folien wird im Patent US 5,766,827 beschrieben. Zur Festlegung des Grades der Schwarzfärbung wird ein Sauerstoffgehalt des Aluminiumoxides von 19 bis 58at% und eine in Transmission gemessene optische Dichte von mindestens 0,3 bei einer Wellenlänge von 200 nm bis 1100 nm festgelegt. Mit den Angaben des Sauerstoffgehaltes und der optischen Dichte sind die Dicke und der Oxidationsgrad und damit auch der Grad der Schwarzfärbung ausreichend festgelegt. Nachteilig ist jedoch, dass die Bestimmung des Sauerstoffgehaltes sehr aufwendig ist und in-line zur Beschichtung nicht durchgeführt werden kann und damit nicht zur Regelung des Verfahrens genutzt werden kann. Der Nachteil, dass die optische Dichte bei opaken Substraten nicht bestimmt werden kann, bleibt außerdem weiterhin bestehen. Damit können die in Patent US 5,766,827 beschriebenen Eigenschaften der schwarzen Aluminiumoxidschicht bei der Herstellung qualitativ hochwertiger Schichten nicht reproduzierbar eingestellt werden.

Insgesamt gibt der gegenwärtige Stand der Technik kein Verfahren an, nach dem bandförmige Substrate bei hoher Produktivität mit schwarzen Aluminiumoxidschichten hoher Farbqualität beschichtet werden können. Insbesondere wird kein Verfahren angegeben, wie die gewünschte Schwarzfärbung einer unterstöchiometrischen Aluminiumoxidschicht zu regeln ist.

Ausgehend von den vorstehenden Nachteilen der nach dem Stand der Technik bekannten Verfahren zum Aufbringen einer schwarzen Aluminiumoxidschicht liegt der vorliegenden Erfindung die Aufgabe zugrunde, ein Verfahren anzugeben, das es erlaubt, mit hoher Produktivität durch reaktive Verdampfung von Aluminium nahezu schwarzes Aluminiumoxid gleichmäßiger Schwarzfärbung auf bandförmigen Substraten abzuscheiden, wobei die bandförmigen Substrate auch opak sein können.

Erfindungsgemäß wird diese Aufgabe durch ein Verfahren nach Anspruch 1 erreicht. Vorteilhafte Ausgestaltungen sind in den Ansprüchen 2 bis 25 angegeben.

Erfindungsgemäß wird durch Verdampfung von Aluminium und Zufuhr von Sauerstoff in den Aluminiumdampf eine bezüglich des Sauerstoffanteils unterstöchiometrische schwarze Aluminiumoxidschicht mit einer Aluminiummassenbelegung abgeschieden, deren Wert über einem bestimmten Grenzwert von mindestens 15 µg/cm² liegt. Des Weiteren wird in-line zur Beschichtung ein die Reflexionseigenschaften der beschichteten Folie auf der Schichtseite charakterisierender Messwert bestimmt und anhand von Referenzproben ein Zielbereich für den Messwert festgelegt, wobei
a) bei im Wesentlichen konstanter Aluminiummassenbelegung der Aluminiumoxidschicht
   die Menge des in den Verdampfungsraum gegebenen Sauerstoffs derart geregelt wird oder
b) bei im Wesentlichen konstanter Menge des in den Verdampfungsraum gegebenen Sauerstoffs die Aluminiumverdampfungsrate derart geregelt wird,
dass der Messwert im Zielbereich liegt.

Zur Beschreibung des Grades der Schwarzfärbung im Sinne der Erfindung wird der visuelle Farbeindruck in Reflexion herangezogen. Dieser wird oberhalb des Grenzwertes der Al-Massenbelegung überraschend wenig durch die Schichtdicke beeinflusst. Dadurch werden verschiedene Vorteile erzielt. Insbesondere kann eine Regelung der Al-Verdampfungsrate entfallen, da ein Erreichen der verdampften Mindestmenge an Aluminium garantiert werden muss. Zur messtechnischen Erfassung des visuellen Eindruckes der schwarzen Schicht ist es vorteilhaft, Wertebereiche für die Parameter a*, b* und L* im L*a*b*-Farbenraum CIE 1976 [DIN 5033] zu definieren und deren Einhaltung zu überwachen. Absolut schwarz wäre eine Schicht, wenn L*=0 ist, d.h. kein Licht reflektiert wird. Dies kann jedoch in der Praxis kaum erreicht werden. Mit Vorteil kann zur Charakterisierung der Reflexionsseigenschaften der Wert L* im CIELAB L*a*b* Farbraum 1976 oder ein mit L* streng korrelierender Wert herangezogen werden. Vorteilhafterweise werden die Reflexionseigenschaften innerhalb eines durch die Anforderungen an das Produkt vorgegebenen Zielbereiches gehalten. Besonders vorteilhaft lässt sich das realisieren, wenn als bandförmiges Substrat ein opakes Substrat, z. B. weiße PET-Folie eingesetzt wird.

Unterhalb des Minimalwertes der Aluminiummassenbelegung lässt sich über den gesamten Bereich der Sauerstoffzugabe kein Arbeitspunkt finden, bei dem die Schicht eine ausreichend schwarze Färbung aufweist. Dies ist teilweise damit zu erklären, dass unterhalb einer Mindestschichtdicke die optische Dichte des Aluminiumoxides zu gering ist, so dass durch das Substrat hindurchtretendes Licht oder am Substrat reflektiertes Licht sichtbar wird. Oberhalb der Mindestschichtdicke verschwindet jedoch der Einfluss des Substrates, so dass der Prozess nahezu unabhängig von Schichtdickenschwankungen, bei Einhaltung der Mindestschichtdicke, wird. Eine weitere mögliche Erklärung für diesen Effekt ist, dass bei der Schwarzfärbung neben dem Oxidationsgrad des Aluminiums auch Struktureffekte eine Rolle spielen, die die Lichtabsorption beeinflussen. Aus diesem Grund ist der erfindungsgemäße Minimalwert der Aluminiummassenbelegung keine von technologischen Parametern unabhängige Größe, sondern für jeden Satz von Prozessparametern erneut zu ermitteln. Außerdem hängt er von den Qualitätsanforderungen ab, die an das beschichtete Produkt gestellt werden. Oberhalb einer bestimmten Aluminiummassenbelegung bildet sich eine Struktur heraus, die zu einer breitbandigen starken Lichtabsorption führt. Dies ist teilweise bereits oberhalb von 15 µg/cm², häufig oberhalb von 20 µg/cm², mit Sicherheit jedoch oberhalb von 35 µg/cm² der Fall. Durch Einhaltung einer Mindest-Aluminiummassenbelegung wird auch die Prozessführung erleichtert, da nur zu gewährleisten ist, dass die Mindest-Aluminiummassenbelegung nicht unterschritten wird, die Schwarzfärbung kann dann durch Einstellung nur noch eines Parameters geregelt werden. Dieser Parameter kann bei im Wesentlichen konstanter Aluminiummassenbelegung der Aluminiumoxidschicht die Menge des in den Verdampfungsraum gegebenen Sauerstoffs oder bei im Wesentlichen konstanter Menge des in den Verdampfungsraum gegebenen Sauerstoffs die Alumniumverdampfungsrate sein.
Für eine Anwendung in laserbeschreibbaren Folien ist es vorteilhaft, die Aluminiumverdampfungsrate so einzustellen, dass die Aluminiummassenbelegung der Aluminiumoxidschicht einen maximalen Wert nicht überschreitet, unterhalb dessen noch eine gute Beschreibbarkeit der beschichteten Folie mit einem Laser gewährleistet ist. Besonders vorteilhaft ist eine Einstellung der Al-Massenbelegung auf einen Wert, der etwa in der Mitte zwischen diesem Maximalwert und dem durch die Mindestabsorption bedingten Minimalwert liegt.

In einer vorteilhaften Ausführung werden Schiffchenverdampfer zur Verdampfung des Aluminiums eingesetzt. Schiffchenverdampfer weisen typischerweise Schwankungen der Aluminiumverdampfungsrate von weniger als ±10% auf. Durch diese Eigenstabilität der Aluminiumverdampfungsrate kann damit problemlos eine Mindest-Aluminiummassenbelegung eingehalten werden. Gemäß einer vorteilhaften Ausführungsform wird zu Beginn der Bedampfung die Aluminiumbedampfungsrate eingestellt indem reines Aluminium aufgedampft wird und die Aluminiummassenbelegung mit bekannten Mitteln gemessenen wird. Das kann z. B. durch eine Messung der optischen Dichte oder durch eine Leitfähigkeitsmessung erfolgen. Im weiteren Beschichtungsprozess wird dann die Aluminiumbedampfungsrate mit bekannten Mitteln auf dem zu Beginn eingestellten Wert gehalten. Zur Prozessregelung muss dann nur noch die Sauerstoffzugabe so geregelt werden, dass der Farbwert in einem definierten Arbeitsbereich gehalten wird.

Erfindungsgemäß wird das Substrat mit einer Mindestmenge von Aluminium belegt. Statt einer Aluminium- oder Aluminiumoxidschichtdicke wird hier die Aluminiummassenbelegung vorgegeben. Diese Größe ist unabhängig davon, ob das Aluminium metallisch oder gebunden in Aluminiumoxid vorliegt. Die Aluminiummassenbelegung lässt sich sowohl bei Aluminiumoxidschichten als auch Aluminiumschichten mittels Röntgenfluoreszenzmessung (XRF) bestimmen. Bei Aluminiumschichten lässt sich die Aluminiummassenbelegung jedoch auch aus Messung der Leitfähigkeit oder der optischen Dichte bestimmen. Vorteilhaft ist es, wenn die Aluminiumverdampfung aus durch Stromdurchfluss erhitzten Keramikschiffchen mit Al-Drahtzufuhr erfolgt und die Al-Beschichtungsrate durch Regelung der Al-Drahtzufuhr eingestellt wird. Die Al-Massenbelegung kann dann durch Einstellung der Bandgeschwindigkeit erfolgen. Eine vorteilhafte Ausgestaltung besteht darin, die Bestimmung der Aluminiummassenbelegung mittel in-situ Röntgenfluoreszenzmessung vorzunehmen.

Gemäß einer vorteilhaften Ausführung wird die Schichtfärbung ermittelt durch Messung des von der beschichteten Folie reflektierten Lichtes. Vorteilhaft ist es, wenn als Messgröße zur Charakterisierung der Reflexionseigenschaften die Reflexion integriert über einen im sichtbaren Licht liegenden Wellenlängenbereich gemessen wird. Besonders vorteilhaft ist es, wenn die Aluminiumverdampfung aus durch Stromdurchfluss erhitzten Keramikschiffchen mit Al-Drahtzufuhr erfolgt und die Messung des reflektierten Lichtes mittels Sensoren erfolgt, wobei jeweils ein Sensor auf dem bandförmigen Substrat eine jeweils einem Verdampfer zugeordnete Bahn erfasst.
Vorteilhafterweise erfolgt die Messung des reflektierten Lichts im Reflexionswinkel zur Beleuchtung. Besonders vorteilhaft ist es dabei, wenn sowohl die Beleuchtung des beschichteten Substrates als auch die Messung des reflektierten Lichtes im Wesentlichen senkrecht zur Schichtoberfläche erfolgt.
Eine weitere vorteilhafte Ausgestaltung des erfindungsgemäßen Verfahrens ergibt sich, wenn bei der Verwendung von transparenter Substratfolie die Intensität oder spektrale Verteilung des von einer Walze des Bandlaufwerkes mit reflektierender Oberfläche durch die beschichtete Folie hindurch reflektierten Lichtes gemessen und dieses Signal zur Regelung der Reflexionseigenschaften der Folie verwendet wird.

Bei Einhaltung der Mindest-Aluminiummassenbelegung kann durch in-line Bestimmung der Reflexionseigenschaften der Sauerstofffluss so geregelt werden, dass die beschichtete Folie die gewünschte Schwarzfärbung aufweist. Anhand von Referenzproben kann ein Zielbereich für die Messwerte der Reflexionseigenschaften festgelegt werden. Die Regelung des Sauerstoffflusses erfolgt dann so, dass die Messwerte der Reflexionseigenschaften immer im gewünschten Zielbereich liegen. Vorteilhafterweise wird die Aluminiummassenbelegung auf einen Wert eingestellt wird, bei dem bei konstanter Zusammensetzung der Aluminiumoxidschicht die Abhängigkeit der Reflexionseigenschaften von der Schichtdicke minimal sind.

Vorteilhaft ist es, wenn die Aluminiumverdampfung aus durch Stromdurchfluss erhitzten Keramikschiffchen mit Al-Drahtzufuhr erfolgt und die Zufuhr von Sauerstoff dergestalt erfolgt, dass jeweils einem Verdampferschiffchen eine oder mehrere Sauerstoffeinlassdüsen räumlich zugeordnet sind, deren Sauerstofffluss unabhängig von denen der den anderen Verdampferschiffchen zugeordneten Sauerstoffdüsen regelbar ist.

Erfindungsgemäß werden nahezu schwarze Schichten mit einem jedoch leicht metallischen Glanz abgeschieden. Unter einer schwarzen Färbung mit leicht metallischem Glanz ist im Sinne der Erfindung die Schwarzfärbung zu verstehen, die sich bei einem Oxidationsgrad im Übergangsbereich zwischen metallisch (d. h. ohne Sauerstoff) und schwarz einstellt. Dabei wird dem Aluminiumdampf soviel Sauerstoff zugeführt, dass unterstöchiometrisches Aluminiumoxid abgeschieden wird, welches bedingt durch ein Sauerstoffdefizit eine metallisch-schwarze Färbung mit einer etwas höheren als der am fertigen Produkt gewünschten Reflexion aufweist. Erst durch eine anschließend stattfindende Nachoxidation verliert die Schicht ihren metallischen Glanz und wird in eine im Wesentlichen schwarze den Produktanforderungen entsprechende Färbung überführt. Die Nachoxidation kann dabei durch Lagerung oder Umwickeln der beschichteten Folie in sauerstoffhaltiger Umgebung erfolgen.
Der Arbeitspunkt der Sauerstoffzufuhr, bei der die Schicht eine schwarze Färbung mit leicht metallischem Glanz aufweist, wird so gewählt, dass nach dem Prozess der Nachoxidation sich die gewünschte schwarze Färbung einstellt. Dieser Arbeitspunkt ist gegebenenfalls durch Vorversuche zu ermitteln. Dazu wird vorteilhafterweise eine Beschichtung mit knapper Sauerstoffzufuhr durchgeführt und die Probeschicht vor und nach der vorgesehenen Nachoxidation bzgl. Ihrer Reflexion vermessen. Hat die Nachoxidation zu einer Verringerung der Reflexion geführt, wird bei einer weiteren Probebeschichtung ein Arbeitspunkt mit etwas höherer Sauerstoffzufuhr gewählt und die Auswertung wiederholt. Diese Schritte werden bei Bedarf mehrmals wiederholt, bis sich keine weitere Verringerung Reflexion der nach der Nachoxidation vermessenen Schicht nachweisen lässt. Hat die Nachoxidation zu einer Erhöhung der Reflexion geführt, wird in analoger Weise ein Arbeitspunkt mit verringerter Sauerstoffzufuhr gewählt. Durch fein abgestufte Veränderung des Arbeitspunktes bei derartigen Probebeschichtungen lässt sich der optimale Arbeitspunkt, bei dem sich nach einem technologisch sinnvollen Nachoxidationsschritt eine minimale Reflexion der beschichteten Folie ergibt, zuverlässig ermitteln.

Durch die beschriebene Wahl des Arbeitspunktes der Sauerstoffzugabe sind verschiedene erfindungsgemäße Vorteile verbunden. Ein Vorteil besteht darin, dass vermieden wird, dass durch den in der Praxis nicht zu vermeidenden Prozess der Nachoxidation eine unerwünschte Aufhellung der Schicht eintritt. Ein weiterer Vorteil besteht darin, dass die höhere Reflektivität im Arbeitspunkt zu einer geringeren thermischen Belastung der Folie durch Wärmestrahlung der Verdampfungseinheit führt. Ein weiterer Vorteil besteht darin, dass das Prozessfenster der Sauerstoffzugabe im Bereich des Arbeitspunktes größer ist als im Punkt der optimalen Schwarzfärbung. Führt man die Beschichtung im Punkt der optimalen Schwarzfärbung durch, können schon geringe und kurzzeitige, in der Praxis kaum vermeidbare, Verringerungen der Aluminiumverdampfungsrate zu einer unerwünschten Schichtaufhellung führen.

An einem Ausführungsbeispiel wird das erfindungsgemäße Verfahren näher erläutert. Die zugehörigen Figuren zeigen dabei:
- Fig. 1: eine typische Abhängigkeit der in-line ermittelten Schwarzfärbung von der Zufuhr von Sauerstoff in den Aluminiumdampf
- Fig. 2: den prinzipiellen Aufbau einer Anlage zum Beschichten von Kunststofffolien mit Aluminiumoxid
- Fig. 3: die Abhängigkeit der Reflexion von der Al-Massenbelegung
- Fig. 4: die Abhängigkeit der Reflexion vom eingeleiteten Sauerstofffluss

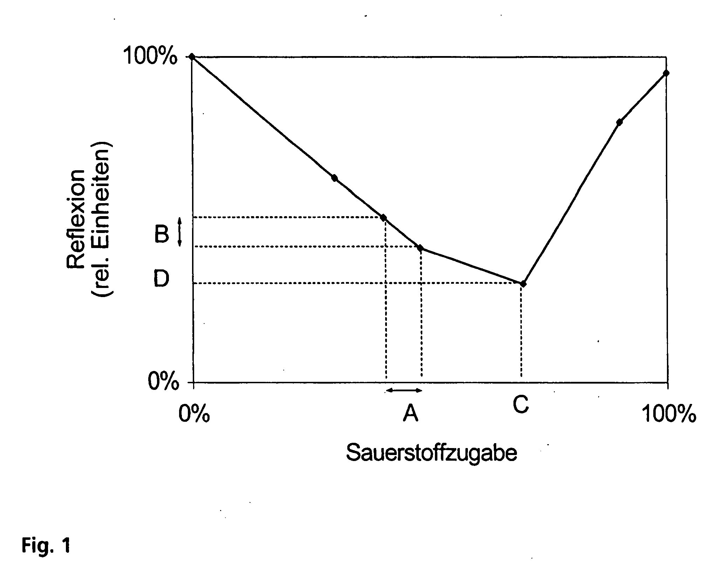

Fig. 1 zeigt schematisch eine typische Abhängigkeit der in-line ermittelten Schwarzfärbung von der Zufuhr von Sauerstoff in den Aluminiumdampf. Der Grad der Schwarzfärbung ist hierbei bei konstanter Al-Massenbelegung durch die Intensität des reflektierten Lichtes bestimmt. Die Angaben der Reflektivität sind relativ. Für eine metallische Schicht wurden 100 % angenommen. Die Angaben der Sauerstoffzugabe sind ebenfalls relativ. 0 % bezieht sich auf keine Sauerstoffzugabe, der Wert von 100 % entspricht der Sauerstoffzugabe, bei der stöchiometrisches Aluminiumoxid abgeschieden wird. Bei einem Sauerstofffluss von 0 % wird reines Aluminium abgeschieden, der Reflexionswert ist entsprechend hoch. Mit steigender Sauerstoffzugabe nimmt die Aluminiumoxidschicht eine dunkle Färbung an, bis bei einer Sauerstoffzugabe (C) der Reflexionswert ein Minimum (D) erreicht, dass dem optimalen Wert der Schwarzfärbung entspricht. Bei weiterer Erhöhung der Sauerstoffzugabe wird die Aluminiumoxidschicht allmählich transparent und es erhöht sich der Reflexionswert aufgrund des vom Substrat oder einer dahinter befindlichen Oberfläche reflektierten Lichtes. Die angestrebte Schwarzfärbung entspricht dem Minimum des Reflexionswertes. Der vorteilhaften Ausführung gemäß wird jedoch für die Beschichtung ein Arbeitsbereich der Sauerstoffzugabe (A) gewählt, der bei einer geringeren Sauerstoffzugabe liegt und der durch einen höheren Reflexionswert (B) definiert ist. Dieser höhere Reflexionswert wiederum ist dadurch definiert, dass sich nach einem Prozess der Nachoxidation der optimale Wert der Schwarzfärbung einstellt. Dieser Arbeitsbereich (B) kann experimentell ermittelt werden, indem man bei konstanter Aluminiummassenbelegung die Sauerstoffzugabe gezielt variiert und die Proben dann der Nachoxidation unterwirft. Nach erfolgter Nachoxidation wählt man durch Auswertung des Grades der Schwarzfärbung den Arbeitsbereich aus.
Die Nachoxidation kann erfolgen durch gezielte oder mit der weiteren Verarbeitung der Folie verbundenen Lagerung oder Umwickeln der Folie in sauerstoffhaltiger Umgebung (Luft).
Als Kunststofffolie kann zum Beispiel weiße PET-Folie eingesetzt werden. Beschichtet man dieses Material mit schwarzem Aluminiumoxid, lassen sich daraus laserbeschreibbare Etiketten herstellen. Der Laser verändert die schwarze Aluminiumoxidschicht derart, dass die weiße Substrat-Folie in der Spur des Lasers einen guten Kontrast zum schwarzen Aluminiumoxid bildet.

Im Folgenden wird ein Beispiel des erfindungsgemäßen Verfahrens beschrieben.

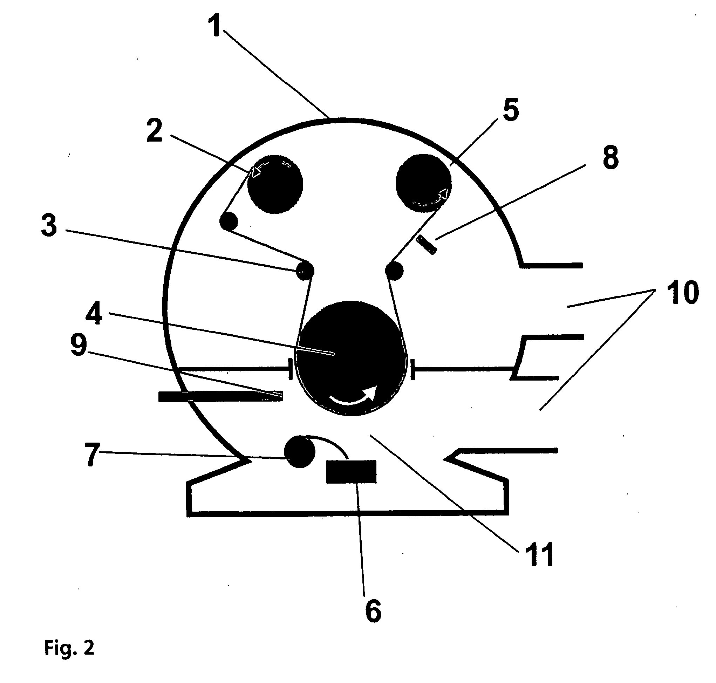

Fig.2 zeigt den prinzipiellen Aufbau einer Anlage zum Beschichten von Kunststofffolien mit Aluminiumoxid. In einem Rezipienten (1) wird mittels Vakuumpumpen, die über Pumpstutzen (10) an den Rezipienten (1) angeschlossen sind, ein Vakuum erzeugt. Die Kunststofffolie wird von einer Folienrolle (2) abgewickelt und über ein Bandlaufwerk bestehend aus Walzen (3) über eine Kühlwalze (4) durch den Beschichtungsraum (11) bewegt und dann auf einem Aufwickel (5) wieder aufgewickelt. Im Beschichtungsraum (11) befinden sich Verdampferschiffchen (6) zur Verdampfung des Aluminiums. Das Aluminium wird als Draht von einer Drahtrolle (7) kontinuierlich den Verdampferschiffchen (6) zugeführt. Mittels optischer Sensoren (8) werden in-line zur Beschichtung die Reflexionseigenschaften der beschichteten Folie gemessen. Jedem Verdampferschiffchen ist hierbei ein Sensor zugeordnet, d. h. der Sensor befindet sich quer zur Folie gesehen an der gleichen Position wie das zugeordnete Verdampferschiffchen. In den Verdampfungsraum wird über Sauerstoffeinlassdüsen (9) Sauerstoff eingelassen. Hierbei ist wiederum jedem Verdampferschiffchen eine Düse bzw. mehrere Düsen zugeordnet, wobei der Gasfluss durch jede Düse unabhängig von dem Gasfluss der anderen Düsen einstellbar ist.

Die Bestimmung der Reflexionseigenschaften der beschichteten Folie erfolgte nach folgendem Verfahren:
- Die Beleuchtungsquelle als auch der optische Sensor befinden sich in einem Messkopf, wobei Beleuchtung als auch die Messung des reflektierten Lichtes ca. rechtwinklig zur Oberfläche der Kunststofffolie erfolgen.
- Das von der beschichteten Kunststofffolie reflektierte Licht wird durch den Sensor erfasst und durch ein Spektrometer spektral zerlegt. Aus dem Spektrum wird die über den Wellenlängenbereich 380 nm bis 760 nm integrierte Intensität des reflektierten Lichtes bestimmt. Aufgrund verschiedener Normierungsverfahren zum Ausgleich von Schwankungen der Beleuchtungsquelle sind die so erhaltenen Messwerte nur relative Werte, die im Folgenden mit Iᵣₑₗ bezeichnet werden.

Die Bestimmung der Aluminiummassenbelegung erfolgt außerhalb der Beschichtungsanlage mittels Röntgenfluoreszenzmessmethoden (XRF). Die angegebenen Zählraten (counts per second, cps) sind relative, jedoch mit der Aluminiummassenbelegung streng korrelierende Werte, wobei 2000 cps etwa 20 µg/cm² entsprechen. Diese Korrelation wurde gewonnen, indem Aluminiumschichten auf Siliziumwafern abgeschieden worden und anschließend mit einem Tastschnittgerät die Dicke der Aluminiumschichten bestimmt wurde. Aus der Schichtdicke und der Dichte der Al-Schichten kann die Massenbelegung berechnet werden. Anschließend wurden die Proben mittels XRF vermessen. Die so bei Aluminiumschichten bestimmte Korrelation zwischen XRF-Messwerten und der Aluminiummassenbelegung ist auf Aluminiumoxidschichten übertragbar, da der Sauerstoff das XRF-Messsignal bei dünnen Schichten kaum beeinflusst.

Die Verdampfung des Aluminiums erfolgte aus 6 quer zur Bandlaufrichtung nebeneinander angeordneten Verdampferschiffchen. Der Abstand zwischen den Schiffchen beträgt 105 mm. Jedem Schiffchen ist ein optischer Sensor und eine Sauerstoffeinlassdüse zugeordnet.

In dem betrachteten Beispiel wurde weiße PET-Folie der Dicke 50 µm mit einer schwarzen Aluminiumoxidschicht versehen.

Experimentell wurden die Abhängigkeiten zwischen der Aluminiumverdampfungsrate (r_{Al}), Sauerstofffluss (f_{O2}), Röntgenfluoreszenzmesssignal (XRF) und der Reflexion (Iᵣₑₗ) ermittelt. Die Werte der Aluminiumverdampfungsrate (r_{Al}) beziehen sich auf die Verdampfungsrate für ein Verdampfungsschiffchen, ebenso bezieht sich die Reflexion Iᵣₑₗ und der Sauerstofffluss f_{O2} auf dieses betrachtete Schiffchen.

In einem ersten Versuch wurde der Zusammenhang zwischen dem Wert Iᵣₑₗ und der Schwarzfärbung untersucht. Tab. 1 zeigt die Versuchsparameter.

**Tab. 1**

| | |
|---|---|
| **v_{B}** | 0.23 m/s |
| **r_{Al}** | 1.4 g/min |
| **Sauerstofffluss** | Variiert |

Tab. 2 zeigt die Messergebnisse bzgl. des Zusammenhanges zwischen Iᵣₑₗ und dem visuellen Eindruck der Schwarzfärbung. Von besonderem Interesse sind die Proben 3 und 5. Die Probe 5 zeigte unmittelbar nach der Beschichtung einen den Produktanforderungen entsprechenden Farbeindruck. Nach wenigen Tagen üblicher Lagerung an Luft (ca. 7 Tage) nahm die Probe jedoch durch Nachoxidation eine bräunliche Färbung an, die nicht den Produktanforderungen entspricht. Probe 3 zeigte unmittelbar nach der Beschichtung noch einen leicht metallischen Glanz, der sich jedoch nach wenigen Tagen üblicher Lagerung an Luft verliert. Auf diese Weise wurde ein optimaler Bereich für Iᵣₑₗ von 900 bis 950 bestimmt. Liegt Iᵣₑₗ während der Beschichtung innerhalb dieses Bereiches, dann wird durch die bei der üblichen Lagerung stattfindende Nachoxidation eine optimale Schwarzfärbung erzielt.

Nach einwöchiger Lagerung von Proben des Typs 3 an Luft ergaben sich im CIELB L*a*b* Farbraum folgende Werte:
L* : 2,6 bis 10,9
a* : -1,4 bis 2,1
b* : -2,5 bis 5,5

Als brauchbar im Sinne der Erfindung sind anzusehen:
L*: < 12
a* : -2 bis 2,5
b* : -2,5 bis 5,5.

Eine besonders vorteilhafte Weiterverarbeitung als laserbeschreibbare Folien erlaubten Proben, deren L*-Wert unter 9 lag.

**Tab. 2**

| **Proben -Nr.** | **Sauerstofffluss [sccm]** | **visueller Eindruck der Schwarzfärbung** | **Iᵣₑₗ** | **Bemerkung** |
|---|---|---|---|---|
| 1 | 0 | metallisch | 1250 | |
| 2 | 310 | fast schwarz mit leicht metallischen Glanz | 1100 | |
| 3 | 350 | fast schwarz mit leicht metallischen Glanz | 925 | Durch Nachoxidation geht der metallische Glanz verloren und es bildet sich eine optimale Schwarzfärbung heraus. |
| 4 | 380 | fast schwarz mit leicht metallischen Glanz | 800 | durch Nachoxidation entsteht ein brauner Farbton |
| 5 | 420 | schwarz | 650 | |
| 6 | 460 | braun | 500 | |
| 7 | 1200 | Weiße PET-Folie mit optisch transparenter Al₂O₃-Schicht, | 1150 | |

In einem weiteren Experiment wurden ausgehend von dem Parametersatz
v_{B} = 0.23 m/s,
f_{O2} = 350 sccm und
r_{Al} = 1.4 g/min
verschiedene Variation von r_{Al}, f_{O2} und v_{B} durchgeführt.

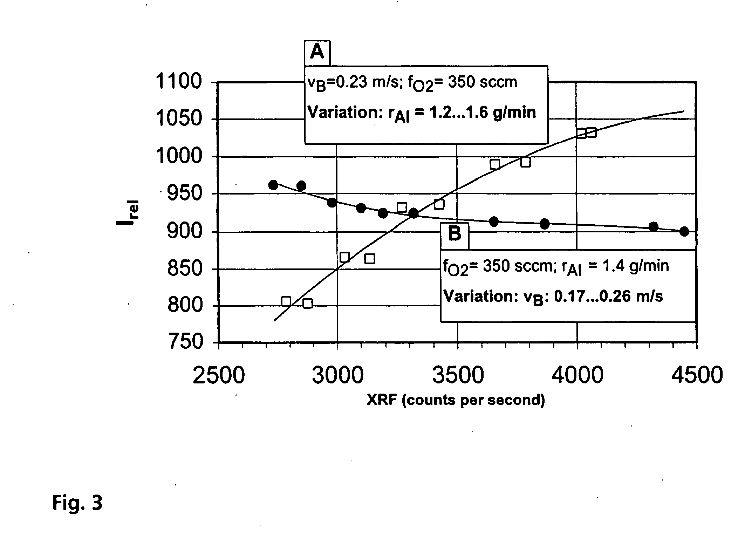

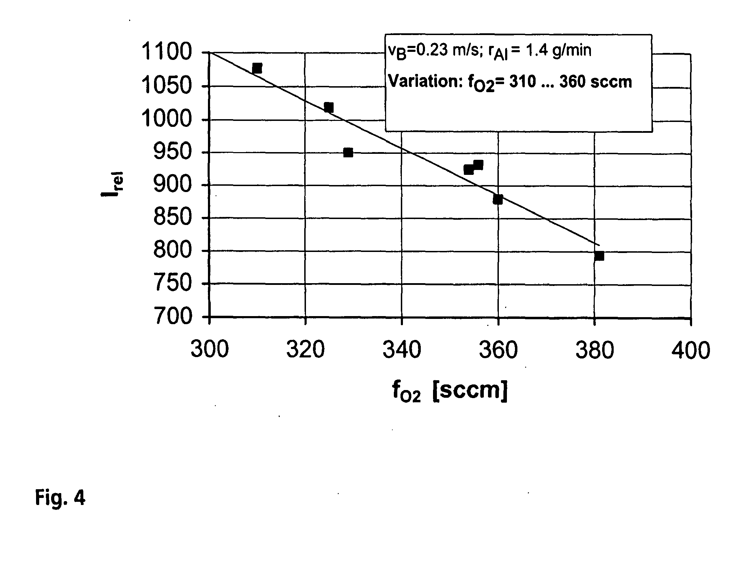

Die Ergebnisse sind in Fig. 3 und Fig. 4 dargestellt. Hierbei ist Folgendes zu berücksichtigen:
- Eine Variation von v_{B} bei konstantem r_{Al} führt zu einer Variation der Aluminiummassenbelegung, jedoch nicht der Stöchiometrie.
- Eine Variation von r_{Al} führt bei konstanter v_{B} und konstantem f_{O2} zu einer Änderung der Stöchiometrie als auch der Aluminiummassenbelegung.

Die Aluminiummassenbelegung wird gemäß oben beschriebener Methode als XRF-Zählrate angegeben.
Der Zielwert für Iᵣₑₗ liegt wie oben beschrieben im Bereich 900...950.

Kurve B in Fig. 3 zeigt die Abhängigkeit der Reflexion Iᵣₑₗ vom XRF-Messwert bei einer Variation der Bandgeschwindigkeit v_{B}. Die Al-Verdampfungsrate als auch der Sauerstofffluss wurden hierbei konstant gehalten, Kurve B zeigt daher die Abhängigkeit der Reflexion von der Aluminiummassenbelegung bei konstanter Zusammensetzung.

In Kurve B ist zu erkennen, dass oberhalb der XRF-Zählrate von etwa 3000 cps die Abhängigkeit des Wertes für Iᵣₑₗ von der Zählrate relativ schwach ist. Oberhalb dieser Zählrate lässt sich der Prozess daher recht gut durch Einstellung von f_{O2} regeln. Weiterhin wurde festgestellt, dass sich unterhalb dieser Zählrate von 3000 cps eine schwarze Färbung nicht mehr erzielen lässt.

## Patentansprüche

1. Verfahren zur Vakuumbeschichtung von bandförmigen bewegten Substraten mit einer schwarzen Aluminiumoxidschicht mittels Verdampfung von Aluminium und Zufuhr von Sauerstoff in den Aluminiumdampf, **dadurch gekennzeichnet, dass** die Aluminiummassenbelegung der Aluminiumoxidschicht auf einen Wert von mindestens 15 µg/cm² eingestellt wird, wobei die Aluminiumoxidschicht mit einem unterstöchiometrischen Sauerstoffanteil abgeschieden wird, und dass in-line zur Beschichtung ein die Reflexionseigenschaften der beschichteten Folie auf der Schichtseite charakterisierender Messwert bestimmt und anhand von Referenzproben ein Zielbereich für den Messwert festgelegt wird, wobei
a) bei im Wesentlichen konstanter Aluminiummassenbelegung der Aluminiumoxidschicht die Menge des in den Verdampfungsraum gegebenen Sauerstoffs derart geregelt wird
oder
b) bei im Wesentlichen konstanter Menge des in den Verdampfungsraum gegebenen Sauerstoffs die Aluminiumverdampfungsrate derart geregelt wird,
dass der Messwert im Zielbereich liegt.

2. Verfahren nach Anspruch 1, **dadurch gekennzeichnet, dass** die Aluminium-massenbelegung der Aluminiumoxidschicht auf mindestens 20 µg/cm² eingestellt wird.

3. Verfahren nach Anspruch 1, **dadurch gekennzeichnet, dass** die Aluminiummassenbelegung der Aluminiumoxidschicht auf mindestens 35 µg/cm² eingestellt wird.

4. Verfahren nach einem der Ansprüche 1 bis 3, **dadurch gekennzeichnet, dass** als bandförmiges Substrat weiße PET-Folie eingesetzt wird.

5. Verfahren nach einem der Ansprüche 1 bis 4, **dadurch gekennzeichnet, dass** die Aluminiummassenbelegung bei konstanter Zusammensetzung der Aluminiumoxidschicht auf einen Wert eingestellt wird, bei dem die Abhängigkeit der Reflexionseigenschaften von der Schichtdicke minimal ist.

6. Verfahren nach einem der Ansprüche 1 bis 4, **dadurch gekennzeichnet, dass** die Aluminiumverdampfungsrate so eingestellt wird, dass die Aluminiummassenbelegung der Aluminiumoxidschicht einen maximalen Wert nicht überschreitet, unterhalb dem noch eine gute Beschreibbarkeit der beschichteten Folie mit einem Laser gewährleistet ist.

7. Verfahren nach Anspruch 6, **dadurch gekennzeichnet, dass** die Aluminiumverdampfungsrate so eingestellt wird, dass die Aluminiummassenbelegung der Aluminiumoxidschicht etwa in der Mitte zwischen dem nach Anspruch 1 bis 3 definierten minimalen Wert und dem in Anspruch 6 definierten maximalen Wert liegt.

8. Verfahren nach Anspruch 1, **dadurch gekennzeichnet, dass** dem Aluminiumdampf soviel Sauerstoff zugeführt wird, dass unterstöchiometrisches Aluminiumoxid abgeschieden wird, das bedingt durch Sauerstoffdefizit eine metallisch-schwarze Färbung mit einer etwas höheren als der am fertigen Produkt gewünschten Reflexion aufweist und dass die Schicht durch anschließend stattfindende Nachoxidation ihren metallischen Glanz verliert und dadurch in eine im Wesentlichen schwarze den Produktanforderungen entsprechende Färbung überführt wird.

9. Verfahren nach Anspruch 8, **dadurch gekennzeichnet, dass** die Nachoxidation durch Lagerung in sauerstoffhaltiger Umgebung erfolgt.

10. Verfahren nach Anspruch 8, **dadurch gekennzeichnet, dass** die Nachoxidation durch Umwickeln der beschichteten Folie unter sauerstoffhaltiger Umgebung erfolgt.

11. Verfahren nach einem der Ansprüche 1 bis 10, **dadurch gekennzeichnet, dass** als Messgröße zur Charakterisierung der Reflexionseigenschaften die Reflexion integriert über einen im sichtbaren Licht liegenden Wellenlängenbereich gemessen wird.

12. Verfahren nach Anspruch 11, **dadurch gekennzeichnet, dass** die Messung des reflektierten Lichtes im Reflexionswinkel zur Beleuchtung erfolgt.

13. Verfahren nach Anspruch 12, **dadurch gekennzeichnet, dass** sowohl die Beleuchtung des beschichteten Substrates als auch die Messung des reflektierten Lichtes im Wesentlichen senkrecht zur Schichtoberfläche erfolgt.

14. Verfahren nach einem der Ansprüche 1 bis 13, **dadurch gekennzeichnet, dass** die Bestimmung der Reflexionseigenschaften gemäß der Vorschriften zur Bestimmung des Farbortes im CIELAB L*a*b* Farbraum 1976 erfolgt.

15. Verfahren nach einem der Ansprüche 1 bis 14, **dadurch gekennzeichnet, dass** zur Charakterisierung der Reflexionsseigenschaften der Wert L* im CIELAB L*a*b* Farbraum 1976 oder ein mit L* streng korrelierender Wert herangezogen wird.

16. Verfahren nach Anspruch 15, **dadurch gekennzeichnet, dass** nach erfolgter Nachoxidation L* kleiner als 12 ist.

17. Verfahren nach Anspruch 15, **dadurch gekennzeichnet, dass** nach erfolgter Nachoxidation L* kleiner als 9 ist.

18. Verfahren nach Anspruch 16 oder 17, **dadurch gekennzeichnet, dass** nach erfolgter Nachoxidation a* im Bereich zwischen -2 und 2,5 und b* im Bereich zwischen -2,5 und 5,5 liegt.

19. Verfahren nach einem der Ansprüche 1 bis 18, **dadurch gekennzeichnet, dass** bei der Verwendung von transparenter Substratfolie die Intensität oder spektrale Verteilung des von einer Walze des Bandlaufwerkes mit reflektierender Oberfläche durch die beschichtete Folie hindurch reflektierten Lichtes gemessen und dieses Signal zur Regelung der Reflexionseigenschaften der Folie verwendet wird.

20. Verfahren nach einem der Ansprüche 1 bis 19, **dadurch gekennzeichnet, dass** die Aluminiumverdampfung aus durch Stromdurchfluss erhitzten Keramikschiffchen mit Al-Drahtzufuhr erfolgt und die Al-Beschichtungsrate durch Regelung der Al-Drahtzufuhr eingestellt wird.

21. Verfahren nach einem der Ansprüche 1 bis 20, **dadurch gekennzeichnet, dass** die Einstellung der Aluminium-Massenbelegung bei konstanter Aluminium-Beschichtungsrate durch Einstellung der Bandgeschwindigkeit erfolgt.

22. Verfahren nach einem der Ansprüche 1 bis 21, **dadurch gekennzeichnet, dass** die Aluminiumverdampfung aus durch Stromdurchfluss erhitzten Keramikschiffchen mit Al-Drahtzufuhr erfolgt und dass die Messung des reflektierten Lichtes mittels Sensoren erfolgt, wobei jeweils ein Sensor auf dem bandförmigen Substrat die jeweils einem Verdampfer zugeordnete Bahn erfasst.

23. Verfahren nach einem der Ansprüche 1 bis 22, **dadurch gekennzeichnet, dass** die Aluminiumverdampfung aus durch Stromdurchfluss erhitzten Keramikschiffchen mit Al-Drahtzufuhr erfolgt und das die Zufuhr von Sauerstoff dergestalt erfolgt, dass jeweils einem Verdampferschiffchen eine oder mehrere Sauerstoffeinlassdüsen räumlich zugeordnet sind, deren Sauerstofffluss unabhängig von denen der den anderen Verdampferschiffchen zugeordneten Sauerstoffdüsen regelbar ist.

24. Verfahren nach einem der Ansprüche 1 bis 23, **dadurch gekennzeichnet, dass** die Einstellung der Aluminiummassenbelegung durch Abscheidung einer Aluminiumschicht ohne Einlass von Sauerstoff mittels Messung der optischen Dichte in Transmission oder mittels Messung der Leitfähigkeit in-line zur Beschichtung erfolgt und dieser Wert dann im Wesentlichen durch Konstanthaltung der Al-Verdampfungsrate und der Bandgeschwindigkeit konstant gehalten wird.

25. Verfahren nach einem der Ansprüche 1 bis 24, **dadurch gekennzeichnet, dass** die Bestimmung der Aluminiummassenbelegung mittel in-situ Röntgenfluoreszenzmessung erfolgt.

## Claims

1. Method for vacuum coating of tape-shaped moving substrates with a black aluminium oxide layer by means of evaporating aluminium and feeding oxygen into the aluminium vapour, **characterized in that** the aluminium mass occupancy of the aluminium oxide layer is set to a value of at least 15 µg/cm², the aluminium oxide layer being deposited with a substoichiometric oxygen component, and **in that** in line with the coating a measured value characterizing the reflection properties of the coated film on the layer side is determined, and a target range for the measured value is defined with the aid of reference samples,
a) the amount of the oxygen added to the evaporation space being controlled in conjunction with a substantially constant aluminium mass occupancy of the aluminium oxide layer in such a way,
or
b) the aluminium evaporation rate being controlled in conjunction with a substantially constant amount of the oxygen present in the evaporation rate in such a way,
that the measured value lies in the target range.

2. Method according to Claim 1, **characterized in that** the aluminium mass occupancy of the aluminium oxide layer is set to at least 20 µg/cm².

3. Method according to Claim 1, **characterized in that** the aluminium mass occupancy of the aluminium oxide layer is set to at least 35 µg/cm².

4. Method according to one of Claims 1 to 3, **characterized in that** white PET film is used as tape-shaped substrate.

5. Method according to one of Claims 1 to 4, **characterized in that** the aluminium mass occupancy is set in conjunction with a constant composition of the aluminium oxide layer to a value at which the dependence of the reflection properties on the layer thickness is minimal.

6. Method according to one of Claims 1 to 4, **characterized in that** the aluminium evaporation rate is set such that the aluminium mass occupancy of the aluminium oxide layer does not exceed a maximum value below which good laser inscribability of the coated film is still ensured.

7. Method according to Claim 6, **characterized in that** the aluminium evaporation rate is set such that the aluminium mass occupancy of the aluminium oxide layer lies approximately in the middle between the minimum value defined in accordance with Claims 1 to 3 and the maximum value defined in Claim 6.

8. Method according to Claim 1, **characterized in that** the aluminium vapour is fed so much oxygen as to effect deposition of substoichiometric aluminium oxide which, as a result of oxygen deficit, has a metallic black colour with a somewhat higher reflection than that desired of the finished product, and **in that** the layer loses its metallic sheen through subsequent oxidation taking place thereafter, and is thereby converted into an essentially black colour corresponding to the product requirements.

9. Method according to Claim 8, **characterized in that** the subsequent oxidation is performed by storage in an oxygen containing environment.

10. Method according to Claim 8, **characterized in that** the subsequent oxidation is performed by laminating the coated film in an oxygen containing environment.

11. Method according to one of Claims 1 to 10, **characterized in that** the reflection integrated over a wavelength region lying in visible light is measured as measured variable for the purpose of characterizing the reflection properties.

12. Method according to Claim 11, **characterized in that** the measurement of the reflected light is performed at the reflection angle in relation to the illumination.

13. Method according to Claim 12, **characterized in that** both the illumination of the coated substrate and the measurement of the reflected light are performed in a fashion substantially perpendicular to the layer surface.

14. Method according to one of Claims 1 to 13, **characterized in that** the determination of the reflection properties is performed in accordance with the regulations for determining the colour locus in the CIELAB L*a*b* colour space 1976.

15. Method according to one of Claims 1 to 14, **characterized in that** the value L* in the CIELAB L*a*b* colour space 1976, or a value strongly correlated with L* is used to characterize the reflection properties.

16. Method according to Claim 15, **characterized in that** L* is smaller than 12 after subsequent oxidation has been performed.

17. Method according to Claim 15, **characterized in that** L* is smaller than 9 after subsequent oxidation has been performed.

18. Method according to Claim 16 or 17, **characterized in that** a* lies in the range between -2 and 2.5, b* lies in the range between -2.5 and 5.5 after subsequent oxidation has been performed.

19. Method according to one of Claims 1 to 18, **characterized in that** when use is made of transparent substrate film the intensity or spectral distribution of the light reflected through the coated film by a roller of the tape drive with a reflecting surface is measured, and this signal is used to control the reflection properties of the film.

20. Method according to one of Claims 1 to 19, **characterized in that** the aluminium evaporation takes place from ceramic boats, heated by throughflow of current, with aluminium wire feed, and the aluminium coating rate is set by controlling the aluminium wire feed.

21. Method according to one of Claims 1 to 20, **characterized in that** the setting of the aluminium mass occupancy is performed in conjunction with a constant aluminium coating rate by setting the tape speed.

22. Method according to one of Claims 1 to 21, **characterized in that** the aluminium evaporation takes place from ceramic boats, heated by throughflow of current, with aluminium wire feed, and **in that** the measurement of the reflected light is performed by means of sensors, a sensor on the tape-shaped substrate in each case detecting the track respectively assigned to an evaporator.

23. Method according to one of Claims 1 to 22, **characterized in that** the aluminium evaporation takes place from ceramic boats, heated by throughflow of current, with aluminium wire feed, and **in that** the oxygen is fed in such a way that in each case an evaporator boat is spatially assigned one or more oxygen inlet nozzles whose oxygen flow can be controlled independently of those of the oxygen nozzles assigned to other evaporator boats.

24. Method according to one of Claims 1 to 23, **characterized in that** the setting of the aluminium mass occupancy is performed by depositing an aluminium layer without inlet of oxygen by means of measuring the optical density in transmission, or by means of measuring the conductivity in line with the coating, and this value is then kept constant essentially by keeping constant the aluminium evaporation rate and the tape speed.

25. Method according to one of Claims 1 to 24, **characterized in that** the aluminium mass occupancy is determined by means of in-situ x-ray fluorescence measurement.

## Revendications

1. Procédé d'application sous vide d'une couche noire d'oxyde d'aluminium sur des substrats en forme de bande mis en déplacement, par vaporisation d'aluminium et apport d'oxygène dans la vapeur d'aluminium,
**caractérisé en ce que**
le taux massique d'occupation de la couche d'oxyde d'aluminium par l'aluminium est réglé à une valeur d'au moins 15 µg/cm², la couche d'oxyde d'aluminium étant déposée à une proportion sous-stoechiométrique d'oxygène et
**en ce qu'**en ligne avec le revêtement, une valeur de mesure qui caractérise les propriétés de réflexion du côté de la feuille revêtu de la couche est définie et une plage de valeurs de mesure cible est définie à l'aide d'éprouvettes de référence et **en ce que**
a) lorsque le taux massique d'occupation de la couche d'aluminium par l'aluminium est essentiellement constant, le débit d'oxygène délivré dans l'espace de vaporisation est régulé de telle sorte que la valeur de mesure soit située dans la plage visée ou
b) lorsque le débit d'oxygène délivré dans l'espace de vaporisation est essentiellement constant, le taux de vaporisation de l'aluminium est régulé de telle sorte que la valeur de mesure soit située dans la plage visée.

2. Procédé selon la revendication 1, **caractérisé en ce que** le taux d'occupation massique de la couche d'oxyde d'aluminium par l'aluminium est réglé à au moins 20 µg/cm².

3. Procédé selon la revendication 1, **caractérisé en ce que** le taux d'occupation massique de la couche d'oxyde d'aluminium par l'aluminium est réglé à au moins 35 µg/cm².

4. Procédé selon l'une des revendications 1 à 3, **caractérisé en ce que** comme substrat en forme de bande, il utilise une feuille de PET blanc.

5. Procédé selon l'une des revendications 1 à 4, **caractérisé en ce que** lorsque la composition de la couche d'oxyde d'aluminium est constante, le taux d'occupation massique par l'aluminium est réglé à une valeur pour laquelle la dépendance entre les propriétés de réflexion et l'épaisseur de la couche est minimale.

6. Procédé selon l'une des revendications 1 à 4, **caractérisé en ce que** le taux de vaporisation d'aluminium est réglé de telle sorte que le taux d'occupation massique de la couche d'oxyde d'aluminium par l'aluminium ne dépasse pas une valeur maximale en dessous de laquelle il est encore assuré de pouvoir écrire correctement au laser sur la feuille revêtue.

7. Procédé selon la revendication 6, **caractérisé en ce que** le taux de vaporisation d'aluminium est réglé de telle sorte que le taux massique d'occupation de la couche d'oxyde d'aluminium par l'aluminium soit situé sensiblement au milieu entre la valeur minimale définie en revendications 1 à 3 et la valeur maximale définie en revendication 6.

8. Procédé selon la revendication 1, **caractérisé en ce que** l'on amène à la vapeur d'aluminium suffisamment d'oxygène pour déposer de l'oxyde d'aluminium sous-stoechiométrique qui, à cause du déficit en oxygène, présente une teinte métallique noire dont la réflexion est légèrement plus élevée que celle souhaitée pour le produit terminé et **en ce que** la couche perd son brillant métallique par la post-oxydation qui intervient ensuite et est ainsi amenée à une teinte essentiellement noire qui correspond aux spécifications imposées au produit.

9. Procédé selon la revendication 8, **caractérisé en ce que** la post-oxydation s'effectue par entreposage dans un environnement contenant de l'oxygène.

10. Procédé selon la revendication 8, **caractérisé en ce que** la post-oxydation s'effectue par déroulement de la feuille revêtue dans un environnement contenant de l'oxygène.

11. Procédé selon l'une des revendications 1 à 10, **caractérisé en ce que** comme les grandeurs de mesure qui caractérisent les propriétés de réflexion, on mesure la réflexion intégrée sur une plage de longueur d'onde située dans la lumière visible.

12. Procédé selon la revendication 11, **caractérisé en ce que** la mesure de la lumière réfléchie s'effectue dans l'angle de réflexion de l'éclairage.

13. Procédé selon la revendication 12, **caractérisé en ce que** tant l'éclairage du substrat revêtu que la mesure de la lumière réfléchie s'effectuent essentiellement à la perpendiculaire de la surface de la couche.

14. Procédé selon l'une des revendications 1 à 13, **caractérisé en ce que** la détermination des propriétés de réflexion s'effectue en suivant les prescriptions de détermination de l'emplacement de la couleur dans l'espace des couleurs CIELAB L*a*b* 1976.

15. Procédé selon l'une des revendications 1 à 14, **caractérisé en ce que** pour caractériser les propriétés de réflexion, on utilise la valeur L* de l'espace des couleurs CIELAB L*a*b* 1976 ou une valeur fortement corrélée à L*.

16. Procédé selon la revendication 15, **caractérisé en ce qu'**après la post-oxydation, L* est inférieur à 12.

17. Procédé selon la revendication 15, **caractérisé en ce qu'**après la post-oxydation, L* est inférieur à 9.

18. Procédé selon les revendications 16 ou 17, **caractérisé en ce qu'**après la post-oxydation, a* est compris dans la plage de -2 à 2,5 et b* dans la plage de -2,5 à 5,5.

19. Procédé selon l'une des revendications 1 à 18, **caractérisé en ce que** l'on utilise une feuille de substrat transparente, on mesure l'intensité ou la distribution spectrale de la lumière réfléchie par la surface réfléchissante d'un cylindre du mécanisme d'avancement de la bande à travers la feuille revêtue et on utilise ce signal pour réguler les propriétés de réflexion de la feuille.

20. Procédé selon l'une des revendications 1 à 19, **caractérisé en ce que** la vaporisation d'aluminium s'effectue à partir de navettes en céramique chauffées par passage de courant et avec apport d'un fil d'Al, le taux d'application d'Al étant réglé par régulation de l'amenée de fil d'Al.

21. Procédé selon l'une des revendications 1 à 20, **caractérisé en ce qu'**à un débit constant de revêtement par l'aluminium, le réglage du taux d'occupation massique par l'aluminium s'effectue par ajustement de la vitesse de la bande.

22. Procédé selon l'une des revendications 1 à 21, **caractérisé en ce que** la vaporisation d'aluminium s'effectue à partir de navettes en céramique chauffées par passage de courant et apport d'un fil d'Al et **en ce que** la mesure de la lumière réfléchie s'effectue au moyen de détecteurs, chaque détecteur saisissant sur le substrat en forme de bande la piste associée à un évaporateur respectif.

23. Procédé selon l'une des revendications 1 à 22, **caractérisé en ce que** la vaporisation d'aluminium s'effectue à partir de navettes en céramique chauffées par passage de courant et apport d'un fil d'Al et **en ce que** l'apport d'oxygène s'effectue en associant séparément à chaque navette d'évaporateur une ou plusieurs tuyères d'admission d'oxygène dont le débit d'oxygène peut être régulé indépendamment de celui des autres tuyères d'oxygène associées aux autres navettes d'évaporateur.

24. Procédé selon l'une des revendications 1 à 23, **caractérisé en ce que** le réglage du taux d'occupation massique par l'aluminium s'effectue par dépôt d'une couche d'aluminium sans apport d'oxygène, au moyen de la mesure de la densité optique en transmission ou de la mesure de la conductivité en ligne du revêtement, cette valeur étant ensuite maintenue essentiellement constante en maintenant constant le taux de vaporisation d'Al et la vitesse de la bande.

25. Procédé selon l'une des revendications 1 à 24, **caractérisé en ce que** la détermination du taux d'occupation massique par l'aluminium s'effectue par une mesure in situ de fluorescence par exposition aux rayons X.
